## Europäisches Patentamt

## European Patent Office

## Office européen des brevets

(11) Veröffentlichungsnummer: **0 191 046**
**B1**

(12) # EUROPÄISCHE PATENTSCHRIFT

(45) Veröffentlichungstag der Patentschrift:
19.04.89

(51) Int. Cl.⁴: **G 01 R 27/18, H 02 H 5/10**

(21) Anmeldenummer: **85903838.2**

(22) Anmeldetag: **02.08.85**

(86) Internationale Anmeldenummer:
**PCT/EP 85/00388**

(87) Internationale Veröffentlichungsnummer:
**WO 86/01299 (27.02.86 Gazette 86/05)**

(54) SCHALTUNG ZUR KONTINUIERLICHEN ÜBERWACHUNG DES ERDUNGSWIDERSTANDES ELEKTRISCHER GERÄTE.

(30) Priorität: **07.08.84 DE 3429067**

(43) Veröffentlichungstag der Anmeldung:
**20.08.86 Patentblatt 86/34**

(45) Bekanntmachung des Hinweises auf die Patenterteilung:
**19.04.89 Patentblatt 89/16**

(84) Benannte Vertragsstaaten:
**AT CH DE FR GB IT LI SE**

(56) Entgegenhaltungen:
**DE-A-2 122 140**
**FR-A-1 545 569**
**FR-A-2 460 558**
**US-A-4 298 864**

(73) Patentinhaber: **Elektromanufaktur Zangenstein Hanauer GmbH & Co., D-8471 Altendorf (DE)**

(72) Erfinder: **GIESL, Johann, Stein 11, D-8473 Pfreimd (DE)**

(74) Vertreter: **Wuesthoff, Franz, Dr.- Ing., Patentanwälte Wuesthoff -v. Pechmann- Behrens- Goetz Schweigerstrasse 2, D-8000 München 90 (DE)**

## Beschreibung

Die Erfindung betrifft eine Schaltung zur kontinuierlichen Überwachung des Erdungswiderstandes elektrischer Geräte, deren berührbare elektrisch leitende Bauteile, wie insbesondere das Gehäuse, über einen Schutzleiter mit einem Erdpotential verbunden sind, wobei eine der stromführenden Zuleitung des Gerätes über eine Reihenschaltung mit dem Schutzleiter verbunden ist, welche einen Meßwiderstand und einen Kondensator aufweist (siehe zum Beispiel das Dokument US-A-4 298 864).

Bekanntlich werden insbesondere bei elektrischen Haushaltsgeräten die berührbaren Metallteile, wie z. B. das Gehäuse, zum Schutze des Benutzers vor einem Stromschlag geerdet. Falls bei einem solchen Geräte durch einen Isolationsfehler ein elektrisch leitendes Bauteil unter Spannung steht, erfährt der dieses Bauteil berührende Benutzer trotzdem keinen Stromschlag, da das Bauteil auf Erdpotential liegt.

Beim Stand der Technik sind zwei grundsätzlich verschiedene Schutzschaltungsarten zu unterscheiden, nämlich der sogenannte "Schutzleiteranschluß" und die sogenannte "Nullung".

Beim Schutzleiteranschluß erfolgt am oder im elektrischen Gerät keine galvanische Verbindung zwischen dem sogenannten Nulleiter des Starkstromnetzes und der örtlichen Bezugserde. Vielmehr wird das Gerät mit einem Schutzleiter versehen, welcher alle gefährlichen, berührbaren Metallteile mit der örtlichen Bezugserde (Masse) verbindet. Bei Auftreten eines Isolationsfehlers im Gerät wird ein auf das Gehäuse des Gerätes gelangender Fehlstrom über den Schutzleiter zur Bezugserde abgeleitet. Erreicht dieser Ableitstrom einen bestimmten Schwellwert, so wird üblicherweise über eine Sicherung die Stromversorgung des Gerätes abgeschaltet.

Ist zum Schutz des Benutzers hingegen die sogenannte "Nullung" vorgesehen, so wird der Nulleiter des Versorgungsnetzes am elektrischen Gerät mit der örtlichen Bezugserde verbunden. Der Schutzleiter braucht in diesem Falle nicht getrennt mit der Bezugserde verbunden zu werden, sondern wird vielmehr an der Steckdose (oder im Klemmkasten) mit dem Nulleiter des Versorgungsnetzes verbunden. Tritt bei einer solchen Schutzschaltung ein Isolationsfehler im Gerät auf, so wird der über die äußeren, berührbaren Metallteile fließende Strom über den Schutzleiter zum Nulleiter abgeleitet. Sobald dieser abgeleitete Strom eine vorgewählte Stromstärke übersteigt, wird die Versorgungspannung des Gerätes unterbrochen.

Die bekannten Schutzschaltungen gewährleisten dann keine 100-%-ige Sicherheit für den Benutzer, wenn der Schutzleiteranschluß Mängel aufweist. Sowohl bei dem oben beschriebenen Schutzleiteranschluß als auch der Nullung treten unvermeidlich Leitungswiderstände und Übergangswiderstände an den Klemmstellen oder Steckverbindungen auf. Dementsprechend kann zwischen der Bezugserde und dem berührbaren Metallteil des Gerätes bei schlechten Kontakten ein Serienwiderstand auftreten, der nicht ohne weiteres erkannt wird. Dieser Serienwiderstand zwischen dem berührbaren Metallteil und der Bezugserde kann aber zur Folge haben, daß an dem Metallteil bei einem Isolationsfehler im Gerät eine gefährliche Spannung anliegt.

Zum Schutze der Bedienungspersonen besteht deshalb ein erhebliches Interesse an einer kontinuierlichen Überwachung des Erdungswiderstandes (Widerstand zwischen dem berührbaren Metallteil des Gerätes und der örtlichen Bezugserde). Übersteigt dieser Erdungswiderstand einen bestimmten kritischen Wert, so muß die Spannungsversorgung des Gerätes aus Sicherheitsgründen unterbrochen werden.

Es ist bekannt, zur Überwachung des genannten Erdungswiderstandes getrennt von den üblichen Anschlüssen (Hauptleiter, Nulleiter und ggf. Schutzleiter) über einen besonderen, zusätzlichen Leiter das Gehäuse des Gerätes (und sonstige berührbare Metallteile) mit dem Erdpotential zu verbinden. Es erfolgt eine hochohmige Spannungsmessung zwischen dem Schutzleiter und der zusätzlichen Leitung. Bei einer Vergrößerung des Erdungswiderstandes und einem Isolationsfehler steigt die Spannung an und das betreffende Gerät wird abgeschaltet. Diese getrennte Leitung zur örtlichen Bezugserde ist jedoch in üblichen Installationen nicht vorhanden, so daß sie nicht für jedes Gerät Verwendung finden kann.

Der Erfindung liegt die Aufgabe zugrunde, eine Schaltung zur Überwachung des Erdungswiderstandes elektrischer Geräte zu schaffen, welche keine zusätzliche Leitung erforderlich macht und bei welcher der Erdungswiderstand jederzeit kontinuierlich überprüft wird.

Gemäß der Erfindung wird diese Aufgabe bei eine Schaltung des eingangs genannten Art daß in der Reihenschaltung ein Test-Impulsgenerator angeordnet ist, welcher Spannungsimpulse abgibt, und daß der Spannungsabfall über dem Meßwiderstand mittels eines Spannungsmeßgerätes gemessen und mit einer Vergleichsspannung verglichen wird.

In einer bevorzugten Ausgestaltung der Erfindung gibt der Test-Impulsgenerator Impulse konstanter Spannungsamplitude ab. Die Dauer der durch den Test-Impulsgenerator erzeugten Impulse, der Meßwiderstand und die Kapazität des Kondensators werden so bemessen, daß die Zeitkonstante des aus dem Meßwiderstand und dem Kondensator gebildeten RC-Gliedes wesentlich größer ist als die Anstiegszeit der Impulse. Damit stellt der Kondensator für die Impulse eine im Vergleich zu den übrigen Schaltungsteilen sehr niederohmige Verbindung dar. Ist deshalb der Erdungswiderstand (also der Ohmsche Widerstand zwischen dem metallischen Gehäuse und der Bezugserde) gleich Null, so fällt die volle Spannungsamplitude der vom Test-Impulsgenerator erzeugten Impulse am Meßwiderstand ab.

Ist dagegen der Erdungswiderstand im Störungsfalle verschieden von "Null", so fällt sowohl über den Meßwiderstand als auch den Erdungswiderstand jeweils eine bestimmte Spannung ab. Die Gesamt-Spannung des Testimpulses wird also in zwei Teilbeträge aufgeteilt, welche im gleichen Verhältnis zueinander stehen wie die Beträge der Widerstände (Meßwiderstand und Erdungswiderstand) und welche in der Summe der Amplitude des Testimpulses entsprechen.

Wird somit der Spannungsabfall über dem Meßwiderstand mittels eines Spannungsmeßgerätes gemessen und mit einer vorwählbaren Vergleichsspannung verglichen, so kann aus einer Verringerung des Spannungsabfalles über dem Meßwiderstand auf den Erdungswiderstand geschlossen werden. Fällt der Spannungsabfall über dem Meßwiderstand unter einen vorgegebenen Wert, was ein Ansteigen des Erdungswiderstandes über einen bestimmten Grenzwert anzeigt, so kann die Spannungsversorgung des Elektrogerätes automatisch unterbrochen werden und/oder eine Alarmeinrichtung ausgelöst werden.

Um sicherzustellen, daß auch bei einer Unterbrechung der Schutzerdung, also bei großem oder sogar unendlich großem Erdwiderstand, die Schutzschaltung nicht selbst das berührbare Gehäuse mit einer gefährlichen Spannung versorgt, wird der Kondensator als den Sicherheitsvorschriften entsprechender Berührungs-Schutzkondensator ausgeführt, so daß der von der Netzspannunug selbst (50 oder 60 Hz) verursachte Ableitstrom mit dem überlagerten Strom des Test-Impulsgenerators kleiner bleibt, als der für den menschlichen Körper zulässige Grenzwert. Zu diesem Zwecke wird auch die vom Test-Impulsgenerator erzeugte Spannungsamplitude unterhalb der für den menschlichen Körper gefährlichen Schwellspannung gehalten.

In einer bevorzugten und besonders einfachen Ausgestaltung der Erfindung ist als Test-Impulsgenerator eine Triggerdiode, wie z. B. ein Diac oder eine Vierschichtdiode, vorgesehen.

Auch kann als Test-Impulsgenerator eine Transistorschaltung vorgesehen sein, die so ausgelegt ist, daß bei Anliegen einer äußeren Spannung unterhalb eines bestimmten Schwellwertes ein großer Widerstand vorliegt, während bei einer Spannung oberhalb des Schwellwertes der Widerstand der zweipoligen Transistorschaltung zusammenbricht.

Nachfolgend ist die Erfindung anhand der Zeichnung im einzelnen beschrieben. Es zeigt:

Fig. 1 eine erfindungsgemäße Schaltung;

Fig. 2 ein Zeitdiagramm des Spannungsverlaufs am Punkt 1 der Fig. 1 sowie des Stromverlaufs durch den Meßwiderstand;

Fig. 3 mögliche Isolationsfehler bei einem Elektrogerät und

Fig. 4 eine bevorzugte Ausgestaltung der Erfindung.

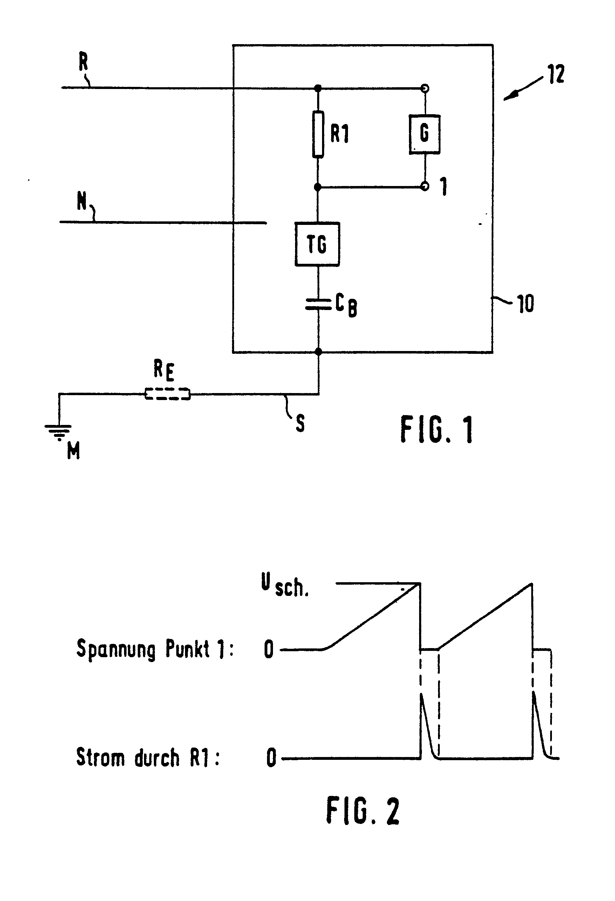

In Fig. 1 ist das mit der erfindungsgemäßen Schutzschaltung ausgestattete Elektrogerät mit dem Bezugszeichen 12 versehen. Das Gehäuse 10 des elektrischen Gerätes 12 soll alle von einem Benutzer berührbaren elektrisch leitenden Bauteile repräsentieren. Das Elektrogerät 12 wird über einen Hauptleiter R und einen Nulleiter N an das Versorgungsnetz angeschlossen. Weiterhin ist ein Schutzleiter S vorgesehen, welcher das Gehäuse 10 mit der örtlichen Bezugserde M verbindet. Der Erdungswiderstand, also der Widerstand zwischen dem Gehäuse 10 und der örtlichen Bezugserde M, ist mit $R_E$ bezeichnet. Bei vorschriftsmäßiger Schaltung ist der Erdungswiderstand $R_E$ praktisch gleich Null.

Zwischen den Hauptleiter (Phase) R und das Gehäuse 10 sowie den Schutzleiter S sind ein Meßwiderstand $R_1$, ein Test-Impulsgenerator TG und ein Kondensator $C_B$ in Reihe geschaltet.

Der Test-Impulsgenerator TG gibt Impulse mit konstanter Spannungsamplitude ab. Die Impulslänge ist so bemessen, daß die Zeitkonstante aus dem Meßwiderstand $R_1$ und dem Kondensator $C_B$ deutlich größer ist als die Impulsanstiegszeit. Der Kondensator $C_B$ stellt somit für die Test-Impulse eine im Vergleich zu den übrigen Schaltungskomponenten sehr niederohmige Verbindung dar. Nimmt man an, daß der Erdungswiderstand $R_E$ den Wert 0 Ohm hat, dann fällt die gesamte Amplitude $U_T$ der Impulse des Test-Impulsgenerators TG am Meßwiderstand $R_1$ ab. Ist dagegen der Erdungswiderstand $R_E$ nicht gleich Null, sondern nimmt einen endlichen Wert an, dann fällt die Spannungsamplitude $U_T$ des Test-Impulsgenerators TG im Verhältnis der Widerstände sowohl am Meßwiderstand $R_1$ als auch am Erdungswiderstand $R_E$ ab. Dabei gelten folgende Beziehungen:

$$U_E : U_1 = R_E : R_1$$
$$U_E + U_1 = U_T$$

Dabei sind $U_E$ und $U_1$ die Spannungsabfälle über dem Erdungswiderstand $R_E$ bzw. dem Meßwiderstand $R_1$.

Bei einem Ansteigen des Erdungswiderstandes $R_E$ wird demzufolge bei gleichbleibender Amplitude der Impulse des Test-Impulsgenerators TG der Spannungsabfall $U_1$ über dem Meßwiderstand $R_1$ abnehmen. Ein unerwünschtes Ansteigen des Erdungswiderstandes $R_E$ über einen bestimmten Grenzwert kann somit unmittelbar aus dem Absinken des Spannungsabfalles $U_1$ über dem Meßwiderstand $R_1$ ermittelt werden. Das Absinken des Spannungsabfalles $U_1$ wird mit

einem Spannungsmeßgerät G gemessen und dort mit einem vorgewählten Wert verglichen. Sobald der Spannungsabfall $U_1$ einen vorbestimmten Wert unterschreitet wird die Spannungsversorgung des Elektrogerätes 12 oder eines bestimmten Teiles dieses Gerätes unterbrochen und/oder eine Alarmeinrichtung ausgelöst.

Um sicherzustellen, daß bei einer Unterbrechung der Schutzerdung, also einem großen oder sogar unendlich großen Wert des Erdungswiderstandes $R_E$, keine gefährliche Spannung durch die Schaltung auf das Gehäuse 10 übertragen wird, wird der Kondensator $C_B$ als den Sicherheitsvorschriften entsprechender Berührungs-Schutzkondensator ausgeführt, so daß bei einer Berührung der von der Netzspannung R, N (50 oder 60 Hz) erzeugte Ableitstrom sowie der überlagerte Mittelwert des vom Test-Impulsgenerator TG erzeugten Impulsstromes kleiner bleibt, als der den Sicherheitsvorschriften entsprechende Grenzwert. Auch wird der Test-Impulsgenerator TG so ausgelegt, daß die Amplitude der von ihm abgegebenen Spannung unterhalb einer ungefährlichen, zulässigen Kleinspannung bleibt.

Hierzu wird der Test-Impulsgenerator TG als Triggerdiode, wie beispielsweise ein Diac, ausgestaltet. Der Diac bleibt solange hochohmig, bis die an seinen beiden Anschlüssen anliegende Spannung einen bestimmten Grenzwert erreicht. Nach Überschreiten der Grenzspannung schaltet der Diac in einen niederohmigen Zustand um, wobei die Spannung an seinen beiden Anschlüssen auf sehr niedrige Werte zusammenbricht. Sobald der durch den Diac fließende Strom einen bestimmten Grenzwert (Haltestrom) unterschreitet, kehrt er wieder in seinen hochohmigen Ausgangszustand zurück.

In Fig. 2 sind die dementsprechenden Spannungsverhältnisse am Meßpunkt 1 der Fig. 1 sowie der Stromverlauf durch den Meßwiderstand $R_1$ schematisch als Funktion der Zeit dargestellt. Steigt die Spannung am Hauptleiter R vom Wert 0 ausgehend (sinusförmig) an, dann ergibt sich zunächst kein Spannungsabfall über den Meßwiderstand $R_1$ und auch keine Spannungsänderung am Kondensator $C_B$, da aufgrund des großen Widerstandes des Diacs (Test-Impulsgenerator TG) kein Strom fließt und alle Spannung am Diac abfällt. Dementsprechend steigt die Spannung am Meßpunkt 1 und am Diac parallel mit der Spannung des Hauptleiters R an, wie in Fig. 2 in der oberen Kurve dargestellt ist. Erreicht die Spannung am Diac (TG) den vorgewählten Schwellwert $U_{SCH}$, so schaltet der Diac in seinen niederohmigen Zustand um und die Spannung über den Diac bricht bis auf eine kleine Restspannung $U_{RE}$ zusammen. Im Moment nach dem Zünden des Diacs fließt durch den Meßwiderstand $R_1$ ein Strom, der die Größe $(U_{SCH} - U_{RE}): R_1$ hat und in Fig. 2 in der unteren Kurve dargestellt ist. Der Kondensator $C_B$ wird durch diesen Strom mit der Zeitkonstanten $R_1$ x

$C_B$ umgeladen, wobei die Stromstärke gemäß Fig. 2, unten, exponentiell abfällt bis der Haltestrom des Diacs unterschritten wird und der Diac damit wieder in seinen hochohmigen Zustand zurückkehrt. Daraufhin beginnt der Zyklus von neuem und die Spannung am Meßpunkt 1 steigt mit der Spannung am Hauptleiter R wieder an bis der Scheitelwert der Halbwelle der sinusförmigen Netzspannung erreicht ist. Der Kondensator $C_B$ ist dann auf eine Spannung aufgeladen, die zwischen der vollen Scheitelspannung der Netzhalbwelle und dem um die Schwellspannung $U_{SCH}$ verminderten Wert liegt. Nach Überschreiten des Scheitelwertes läuft der gleiche Vorgang mit umgekehrter Polarität ab, bis der Scheitelwert der negativen Halbwelle erreicht ist usw. Das Integral $\int i\,(t) \times dt$ der Impulse entspricht dabei dem Wert, der erreicht worden wäre, wenn der Kondensator $C_B$ ohne Zwischenschaltung des Diacs (TG) mit dem Erdanschluß M verbunden worden wäre. Damit ist sichergestellt, daß bei Verwendung eines Berührungsschutzkondensators eine Gefährdung von Personen durch Stromschlag nicht gegeben sein kann.

Wird zwischen den Diac und die örtliche Bezugserde M ein Erdungswiderstand RE endlicher Größe auftreten, so teilt sich die Spannungsamplitude der Test-Impulse $U_T = U_{SCH} - U_{RE}$ wie oben dargelegt auf die beiden Widerstände $R_1$ und $R_E$ auf, und die Zeitkonstante, mit der die Stromamplitude der Impulse abfällt, wächst entsprechend dem Wert $C_B \times (R_1 + R_E)$, während das Integral $\int i\,(t) \times dt$ unverändert bleibt. Das Meßgerät G, das die Spannungsabfälle über dem Meßwiderstand $R_1$ überwacht und bei Unterschreiten eines Grenzwertes Alarm auslöst, kann auch ohne Zwischenschaltung eines Transformators aus dem Netzanschluß seine Spannungsversorgung beziehen.

Bei der in Fig. 1 gezeigten Schaltung wird vorausgesetzt, daß die einzige leitende Verbindung zwischen dem Schutz leiter S und dem Hauptleiter R bzw. dem Nulleiter N über die "echte Erde" erfolgt, d. h. über die Erdung des Schutzleiters S am Geräteort und die Erdung des Nulleiters an anderer Stelle im Versorgungsnetz des Elektroversorgungsunternehmens.

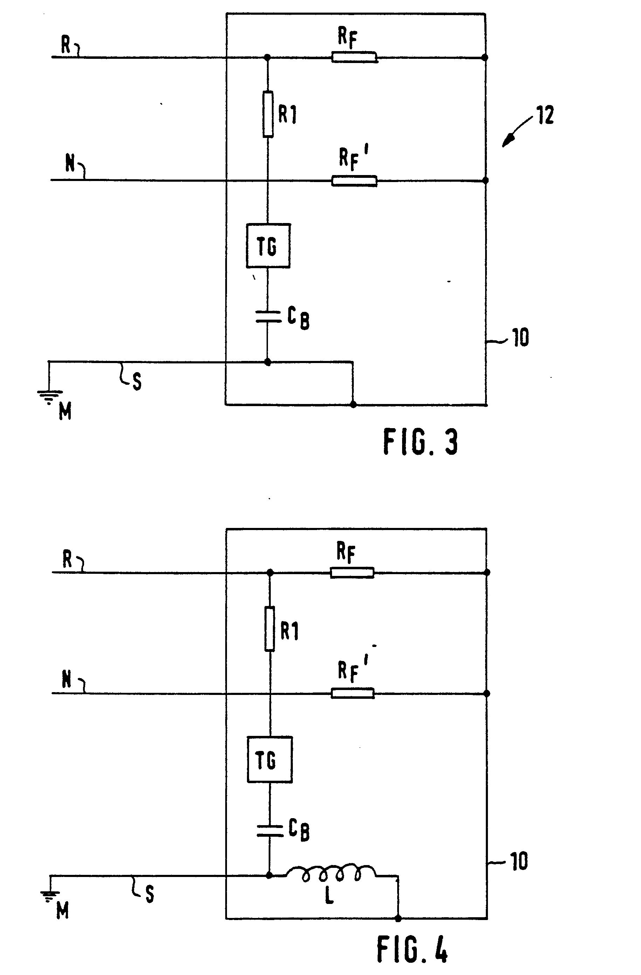

Gemäß Fig. 3 ist es denkbar, daß ein Isolationsfehlwiderstand $R_F$ beispielsweise den Hauptleiter R oder auch ein Isolationsfehlwiderstand $R_F$, den Nulleiter N mit dem Gehäuse 10 des Gerätes 12 verbindet. Ein derartiger, endlicher Isolationsfehlwiderstand $R_F$ bzw. $R_{F'}$ wäre parallel zur Schaltung $R_1$, TG und $C_B$ zwischen dem Hauptleiter R bzw. dem Nulleiter N und dem Schutzleiter S geschaltet. Es ist denkbar, daß der Erdungswiderstand $R_E$ unendlich groß wird und der Isolationsfehlwiderstand $R_F$ bzw. $R_{F'}$ als Kurzschluß gegen Null geht. In diesem Falle würde die Schutzschaltung insofern zu falschen Ergebnissen führen, als sie eine einwandfreie Schutzerdung anzeigen würde.

Zur Vermeidung einer derartigen Fehlanzeige wird gemäß Fig. 4 zwischen dem Eingang des Schutzleiters S, an welchem der Kondensator $C_B$ direkt angeschlossen ist, und dem Gehäuse 10 des Gerätes eine Schutzleiterdrossel L geschaltet, deren Impendanz für die Netzfrequenz (50 - 60 Hz) klein ist, so daß sie keinen erheblichen Spannungsabfall für einen Ableitstrom darstellt. Für die kurzen Impulse des Test-Impulsgenerators TG ist jedoch die Impedanz dieser Schutzleiterdrossel L, welche mit dem Isolationsfehlwiderstand $R_F$ bzw. $R_{F'}$ in Reihe liegt, so hoch, daß der Erdungswiderstand $R_E$ praktisch unverfälscht gemessen werden kann.

**Patentansprüche**

1. Schaltung zur kontinuierlichen Überwachung des Erdungswiderstandes elektrischer Geräte, deren berührbare elektrisch leitenden Bauteile, wie insbesondere das Gehäuse, über einen Schutzleiter mit einem Erdpotential verbunden sind, wobei eine der stromführenden Zuleitungen (R, N) des Gerätes (12) über eine Reihenschaltung mit dem Schutzleiter (S) verbunden ist, welche einen Meßwiderstand ($R_1$) und einen Kondensator ($C_B$) aufweist,
dadurch gekennzeichnet,
daß in der Reihenschaltung ein Test-Impulsgenerator (TG) angeordnet ist, welcher Spannungsimpulse abgibt, und daß der Spannungsabfall ($U_1$) über dem Meßwiderstand ($R_1$) mittels eines Spannungsmeßgerätes (G) gemessen und mit einer Vergleichsspannung verglichen wird.

2. Schaltung nach Anspruch 1,
dadurch gekennzeichnet,
daß der Hauptleiter (R) (sogenannte "Phase") über die Reihenschaltung ($R_1$, TG, $C_B$) mit dem Schutzleiter (S) verbunden ist.

3. Schaltung nach einem der vorstehenden Ansprüche,
dadurch gekennzeichnet,
daß die Länge der durch den Test-Impulsgenerator (TG) erzeugten Impulse, der Meßwiderstand ($R_1$) und die Kapazität des Kondensators ($C_B$) so bemessen sind, daß die Zeitkonstante des aus Meßwiderstand ($R_1$) und Kondensator gebildeten RC-Gliedes groß ist im Vergleich zur Impulsanstiegszeit.

4. Schaltung nach Anspruch 1,
dadurch gekennzeichnet,
daß dann, mittels des Spannungsmeßgerätes (G) gemessene Spannungsabfall ($U_1$) unter die Vergleichsspannung abfällt, die Spannungsversorgung des elektrischen Gerätes oder eines Geräteteiles unterbrochen wird.

5. Schaltung nach einem der vorstehenden Ansprüche,
dadurch gekennzeichnet,
daß dann, wenn der mittels des Spannungsmeßgerätes (G) gemessene Spannungsabfall ($U_1$) unter die Vergleichsspannung abfällt, eine Alarmeinrichtung ausgelöst wird.

6. Schaltung nach einem der vorstehenden Ansprüche,
dadurch gekennzeichnet,
daß der Kondensator ($C_B$) als Berührungsschutz-Kondensator ausgebildet wird.

7. Schaltung nach einem der vorhergehenden Ansprüche,
dadurch gekennzeichnet,
daß der Kondensator ($C_B$) derart ausgelegt ist, daß der bei Berührung von der Netzspannung verursachte Ableitstrom sowie der vom Test-Impulsgenerator (TG) verursachte Impulsstrom auch bei Unterbrechung der Erdverbindung zwischen dem elektrisch leitenden Bauteil (10) und dem Erdpotential (M) kleiner bleibt als der für den menschlichen Körper zulässige Grenzwert.

8. Schaltung nach einem der vorhergehenden Ansprüche,
dadurch gekennzeichnet,
daß die Amplitude der vom Test-Impulsgenerator (TG) erzeugten Spannung unter dem für menschliche Berührung zulässigen Grenzwert liegt.

9. Schaltung nach einem der vorhergehenden Ansprüche,
dadurch gekennzeichnet,
daß als Test-Impulsgenerator (TG) eine Triggerdiode, wie z. B. ein Diac oder eine Vierschichtdiode, vorgesehen ist.

10. Schaltung nach einem der Ansprüche 1 bis 8,
dadurch gekennzeichnet,
daß als Test-Impulsgenerator (TG) eine Transistorschaltung vorgesehen ist, die bei Anliegen einer äußeren Spannung unterhalb eines bestimmten Schwellwertes hochohmig und bei Anliegen einer äußeren Spannung oberhalb des bestimmten Schwellwertes niederohmig ist.

11. Schaltung nach einem der vorhergehenden Ansprüche,
dadurch gekennzeichnet,
daß zwischen das elektrisch leitende Bauteil (10) und den Schutzleiter (S) eine Schutzleiterdrossel (L) geschaltet ist, deren Impedanz bei einer Netzfrequenz klein, für die Test-Impulse aber groß ist.

**Claims**

1. A circuit for the continuous watching of the grounding resistor of electrical appliances, the electrically conductive parts of which that may be touched, especially the casing being connected to a ground potential by a protecting conductor, one of the live leads (R, N) of the appliance (12) being connected to the protecting conductor (S) by a series connection comprising a precision resistor ($R_1$) and a capacitor ($C_B$),

characterized in that a test pulse generator (TG) delivering voltage pulses is arranged in the series connection, and in that the voltage drop (U₁) across the precision resistor (R₁) is measured by a voltmeter (G) and compared with a comparative voltage.

2. The circuit as claimed in claim 1, characterized in that the main conductor (R) (so-called "phase") is connected with the protecting conductor (S) by the series connection (R₁, TG, C_B).

3. The circuit as claimed in one of the preceding claims, characterized in that the duration of the pulses generated by the test pulse generator (TG), the precision resistor (R₁), and the capacitance of the capacitor (C_B) are so dimensioned that the time constant of the RC member composed of the precision resistor (R₁) and the capacitor is great as compared to the pulse rise time.

4. The circuit as claimed in claim 1, characterized in that the feeding of voltage of the electrical appliance or part thereof is interrupted when the voltage drop (U₁) measured by the voltmeter (G) drops below the comparative voltage.

5. The circuit as claimed in one of the preceding claims, characterized in that a warning means is released when the voltage drop (U₁) measured by the voltmeter (G) drops below the comparative voltage.

6. The circuit as claimed in one of the preceding claims, characterized in that the capacitor (C_B) is designed so as to afford protection against electric shock.

7. The circuit as claimed in one of the preceding claims, characterized in that the capacitor (C_B) is so designed that the leakage current, caused upon touching, by the mains voltage as well as the pulse current caused by the test pulse generator (TG) remain smaller than the limit value admissible for the human body even if the ground connection is interrupted between the electrically conductive structural member (10) and the ground potential (M).

8. The circuit as claimed in one of the preceding claims, characterized in that the amplitude of the voltage generated by the test pulse generator (TG) lies below the limit value admissible for human contact.

9. The circuit as claimed in one of the preceding claims, characterized in that a trigger diode, such as a diac or four-layer diode is provided as the test pulse generator (TG).

10. The circuit as claimed in one of claims 1 to 8, characterized in that the test pulse generator (TG) is embodied by a transistor circuit which is high ohmic upon application of an external voltage below a certain threshold value and low ohmic upon application of an external voltage above the certain threshold value.

11. The circuit as claimed in one of the preceding claims, characterized in that a protecting conductor choke (L) is connected between the electrically conductive structural member (10) and the protecting conductor (S), the impedance of the choke being small at a mains frequency but great for the test pulses.

**Revendications**

1. Circuit de contrôle continu de la résistance de terre d'appareils électriques, dont les composants électriquement conducteurs, accessibles au toucher par l'utilisateur, comme en particulier le boîtier, sont reliés, par l'intermediaire d'un conducteur de protection, à un potentiel de terre, l'un des conducteurs (R, N) qui amènent le courant à l'appareil (12) etant relié au conducteur de protection (S) par l'intermédiaire d'un circuit de série qui présente une résistance de mesure (R₁) et un condensateur (C_B), caractérisé, en ce que dans le circuit de série est disposé un générateur d'impulsions de test (TG) qui émet des impulsions de tension; et en ce que la chute de tension (U₁) aux bornes de résistance de mesure (R₁) est mesurée au moyen d'un appareil de mesure (G) de la tension et est comparée à une tension de comparaison.

2. Circuit selon la revendication 1, caractérisé, en ce que le conducteur principal (R) (dit conducteur de "phase") est relié au conducteur de protection (S) par l'intermédiaire du circuit de série (R₁, TG, C_B).

3. Circuit selon l'une des revendications précédentes, caractérisé, en ce que la durée des impulsions produites par le générateur d'impulsions de test (TG), la résistance de mesure (R₁) et la capacité du compensateur (C_B) sont dimensionnées de façon telle que la constante de temps du circuit RC formé par la résistance de mesure (R₁) et par le condensateur est grande en comparaison du temps de montée de l'impulsion.

4. Circuit selon la revendication 1, caractérisé, en ce que si la chute de tension (U₁), mesurée au moyen de l'appareil de mesure (G) de la tension, tombe en-dessous de la tension de comparaison, l'alimentation en courant de l'appareil électrique ou d'une partie de cet appareil est interrompue.

5. Circuit selon l'une des revendications précédentes, caractérisé, en ce que si la chute de tension (U₁), mesurée au moyen de l'appareil de mesure (G) de la tension, tombe en-dessous de la tension de comparaison, un dispositif d'alarme se déclenche.

6. Circuit selon l'une des revendications précédentes, caractérisé, en ce que le condensateur (C_B) est conçu sous forme de condensateur de protection au toucher.

7. Circuit selon l'une des revendications précédentes, caractérisé, en ce que le condensateur ($C_B$) est conçu de façon telle que, même en cas d'interruption de la liaison de terre entre le composant électriquement conducteur (10) et le potentiel de terre (M), le courant de fuite provoqué par le contact accidentel avec la tension du réseau, ainsi que le courant d'impulsion provoqué par le générateur d'impulsions de test (TG) restent inférieurs à la valeur limite autorisée pour le corps humain.

8. Circuit selon l'une des revendications précédentes, caractérisé, en ce que la valeur de la tension produite par le générateur d'impulsions de test (TG) reste inférieure à la valeur limite autorisée pour le contact avec le corps humain.

9. Circuit selon l'une des revendications précédentes, caractérisé, en ce que comme générateur d'impulsions de test (TG), on prévoit une diode à déclenchement, comme par exemple une diode diac ou une diode à quatre couches.

10. Circuit selon l'une des revendications 1 à 8, caractérisé en ce que comme générateur d'impulsions (TG), on prévoit un circuit à transistor qui, en présence d'une tension extérieure inférieure à une valeur de seuil prédéterminée, est à haute résistance ohmique et, en présence d'une tension extérieure supérieure à la valeur de seuil prédéterminée, est à faible résistance ohmique.

11. Circuit selon l'une des revendications précédentes, caractérisé, en ce qu'entre le composant électriquement conducteur (10) et le conducteur de protection (S) est montée une bobine de self (L) de conducteur de protection, dont l'impédance est faible pour une fréquence de réseau, mais grande pour les impulsions de test.

FIG. 1

Spannung Punkt 1:    0

Strom durch R1:    0

FIG. 2

FIG. 3

FIG. 4